# EUROPEAN PATENT APPLICATION

(11) **EP 4 485 506 A1**
(43) Date of publication of application: **01.01.2025**
(21) Application number: 23760002.8
(22) Date of filing: 22.02.2023
(51) Int. Cl.: H01L 21/308, H01L 21/336, H01L 29/78

(54) **COMPOSITION, AND SEMICONDUCTOR SUBSTRATE MANUFACTURING METHOD AND ETCHING METHOD USING SAME**

(30) Priority: 24.02.2022 JP 2022026554
(71) Applicant: MITSUBISHI GAS CHEMICAL COMPANY, INC., Chiyoda-ku Tokyo 100-8324 (JP)
(72) Inventor: OIE, Toshiyuki, Taichung City, 435059 (TW)
(74) Representative: Müller-Boré & Partner Patentanwälte PartG mbB
(86) International application number: PCT/JP2023/006334
(87) International publication number: WO 2023/163002

(57) **Abstract**

Provided is a composition or the like capable of selectively removing silicon while suppressing damage to silicon oxide. A composition including: a quaternary ammonium compound; and at least one cationic surfactant selected from the group consisting of an aryl group-containing cationic surfactant and a heteroaryl group-containing cationic surfactant.

## Description

### Technical Field

The present invention relates to a composition, and a semiconductor substrate manufacturing method and an etching method using the same.

### Background Art

In recent years, miniaturization and high functionality of electronic devices have progressed, and miniaturization and high functionality of semiconductor substrates are required.

For example, in a gate electrode constituting a semiconductor substrate of a metal oxide semiconductor field effect transistor (MOSFET), a combination of silicon oxide and polysilicon has been conventionally used for a gate insulating film and a gate electrode. However, in recent years, a combination of a high dielectric constant (High-k) insulator and a metal gate has been suitably adopted as a gate insulating film and a gate electrode from the viewpoint of realizing high-speed operation and low power consumption.

As a method for manufacturing a semiconductor substrate having such a high dielectric constant (High-k) insulator and a metal gate, a "gate-first method" in which a gate electrode is formed before source-drain formation, a "gate-last method" in which a gate electrode is formed after source-drain formation, and the like are known. Among these, the gate-last method is suitably adopted from the viewpoint of easily obtaining desired transistor characteristics or the like.

In the gate-last method, for example, a semiconductor substrate is manufactured by the following method. That is, first, a sacrificial insulating film made of silicon oxide and a sacrificial gate electrode made of polysilicon are formed, and then impurity implantation and high-temperature annealing are performed to form an extension region. Next, an insulating sidewall is formed, and then impurity implantation and high-temperature annealing are performed to form a source-drain. After silicide is formed on surfaces of the source-drain, an interlayer insulating film is formed. Next, the sacrificial gate electrode made of polysilicon is selectively removed, and subsequently, at least a part of a sacrificial insulator made of silicon oxide is selectively removed. Since the sacrificial insulator is a very thin film (for example, 5 nm or less), it is possible to prevent an adverse effect on a peripheral region by separately performing the removal of the sacrificial gate electrode and the removal of the sacrificial insulator according to the purpose. A high dielectric constant (High-k) insulator is formed in a film shape in the removed sacrificial insulator region and a metal gate is formed in a film shape in the removed sacrificial gate electrode region, whereby a semiconductor substrate having the high dielectric constant (High-k) insulator and the metal gate can be manufactured.

As described above, in the semiconductor substrate manufacturing, in a case where a silicon region containing silicon and a silicon oxide region containing silicon oxide are included, for example, in a case where a sacrificial gate electrode made of polysilicon and a sacrificial insulating film made of silicon oxide are included, a method of selectively removing silicon while suppressing damage to silicon oxide is required.

As a method for selectively removing silicon, for example, Patent Literature 1 describes an invention relating to an etching solution. The etching solution includes water, at least one quaternary ammonium hydroxide compound, optionally at least one alkanolamine compound, at least one water-miscible organic solvent, a predetermined nitrogen-containing compound, and optionally a surfactant. In this case, Patent Literature 1 describes that the etching solution is suitable for selective removal of polysilicon with respect to silicon oxide from a microelectronic device.

### Citation List

### Patent Literature

Patent Literature 1: JP 2020-88391 A

### Summary of Invention

### Technical Problem

In such a situation, there is a demand for new means capable of selectively removing silicon while suppressing damage to silicon oxide.

### Solution to Problem

The present invention includes, for example, the following aspects.
[1] A composition including:
   a quaternary ammonium compound; and
   at least one cationic surfactant selected from the group consisting of an aryl group-containing cationic surfactant and a heteroaryl group-containing cationic surfactant.
[2] The composition according to [1],
   in which the aryl group-containing cationic surfactant is represented by the following Formula (1): 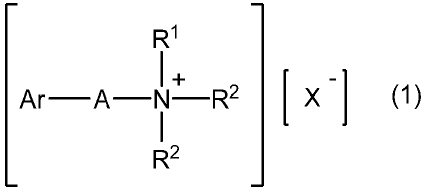 [wherein,
   R¹ is a substituted or unsubstituted alkyl group having 10 to 30 carbon atoms,
   R² is each independently a substituted or unsubstituted alkyl group having 1 to 6 carbon atoms,
   A is a single bond or a substituted or unsubstituted alkylene having 1 to 6 carbon atoms,
   Ar is a substituted or unsubstituted aryl group having 6 to 30 carbon atoms, and
   X⁻ is a halide ion, a hydroxide ion, a sulfate ion, a hydrogen sulfate ion, a sulfite ion, a thiosulfate ion, a nitrate ion, a phosphate ion, a monohydrogen phosphate ion, a dihydrogen phosphate ion, a carbonate ion, a hydrogen carbonate ion, or a carboxylate ion].
[3] The composition according to [2], in which R¹ is a substituted or unsubstituted alkyl group having 10 to 15 carbon atoms.
[4] The composition according to any one of [1] to [3],
   in which the heteroaryl group-containing cationic surfactant is represented by the following Formula (2) or (3): 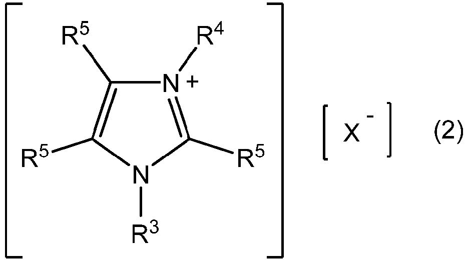 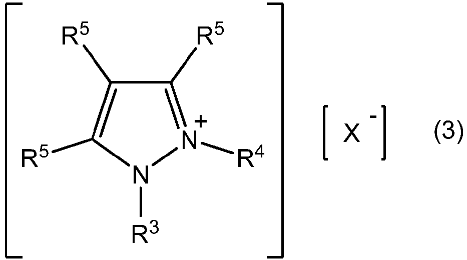 [wherein,
   R³ is a substituted or unsubstituted alkyl group having 10 to 30 carbon atoms,
   R⁴ is a substituted or unsubstituted alkyl group having 1 to 6 carbon atoms,
   R⁵ is each independently a hydrogen atom or a substituted or unsubstituted alkyl group having 1 to 6 carbon atoms, and
   X⁻ is a halide ion, a hydroxide ion, a sulfate ion, a hydrogen sulfate ion, a sulfite ion, a thiosulfate ion, a nitrate ion, a phosphate ion, a monohydrogen phosphate ion, a dihydrogen phosphate ion, a carbonate ion, a hydrogen carbonate ion, or a carboxylate ion].
[5] The composition according to [4], in which R³ is a substituted or unsubstituted alkyl group having 14 to 20 carbon atoms.
[6] The composition according to any one of [1] to [5], further including an organic solvent.
[7] The composition according to [6], in which the organic solvent includes at least one selected from the group consisting of an alkanolamine, an aprotic polar solvent, a monoalcohol, and a polyhydric alcohol.
[8] The composition according to any one of [1] to [7], in which the quaternary ammonium compound includes tetramethylammonium hydroxide (TMAH).
[9] A semiconductor substrate manufacturing method including: a silicon etching step of bringing a semiconductor substrate including a silicon region containing silicon and a silicon oxide region containing silicon oxide into contact with the composition according to any one of [1] to [8].
[10] A semiconductor substrate etching method including: a silicon etching step of bringing a semiconductor substrate including a silicon region containing silicon and a silicon oxide region containing silicon oxide into contact with the composition according to any one of [1] to [8].

### Advantageous Effects of Invention

According to the present invention, a composition or the like capable of selectively removing silicon while suppressing damage to silicon oxide is provided.

### Brief Description of Drawings

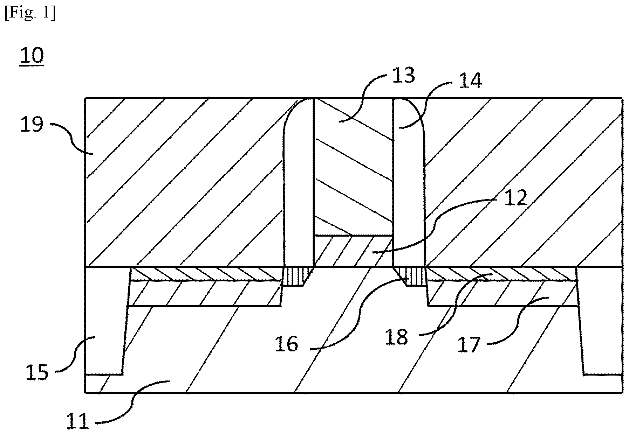

Fig. 1 is a schematic view of a semiconductor substrate (before etching) in a process of manufacturing a MOSFET by a gate-last method.

### Description of Embodiments

Hereinafter, embodiments for carrying out the present invention will be described in detail.

### <Composition>

A composition according to the present invention includes a quaternary ammonium compound and at least one cationic surfactant selected from the group consisting of an aryl group-containing cationic surfactant and a heteroaryl group-containing cationic surfactant.

According to the composition according to the present invention, silicon can be selectively removed while suppressing damage to silicon oxide (hereinafter, it is also referred to as high silicon/silicon oxide etching selectivity or the like). The reason why such a result is obtained is considered that: for example, the cationic surfactant is more quickly adsorbed on a silicon oxide surface than on a silicon surface, so that etching of silicon oxide is easily prevented; and the cationic surfactant is stably adsorbed on a silicon oxide surface by π-π interaction of an aryl group and/or a heteroaryl group of the cationic surfactant, so that an effect of preventing etching of silicon oxide is enhanced. Even in a case where the composition according to the present invention exhibits an effect of the present invention for a reason other than the above, it is included in the scope of the present invention.

### [Quaternary Ammonium Compound]

The quaternary ammonium compound has a function of removing silicon.

The quaternary ammonium compound is not particularly limited, and examples thereof include quaternary ammonium compounds represented by the following Formula (4).

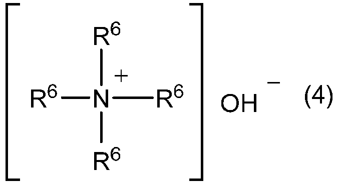

In the above formula, R⁶'s each independently include, as examples, an alkyl group having 1 to 6 carbon atoms and a hydroxyalkyl group having 1 to 6 carbon atoms.

Examples of the alkyl group having 1 to 6 carbon atoms include a methyl group, an ethyl group, a propyl group, an isopropyl group, and a butyl group.

Examples of the hydroxyalkyl group having 1 to 6 carbon atoms include a hydroxymethyl group, a hydroxyethyl group, and a hydroxypropyl group.

R⁶ is preferably an alkyl group having 1 to 3 carbon atoms or a hydroxyalkyl group having 1 to 3 carbon atoms, more preferably a methyl group, an ethyl group, a hydroxymethyl group, or a hydroxyethyl group, still more preferably a methyl group or an ethyl group, and particularly preferably a methyl group.

Specific examples of the quaternary ammonium compound represented by Formula (4) include tetramethylammonium hydroxide (TMAH), tetraethylammonium hydroxide (TEAH), tetrapropylammonium hydroxide, tetrabutylammonium hydroxide, 2-hydroxyethyltrimethylammonium hydroxide (choline), 2-hydroxyethyltriethylammonium hydroxide, 2-hydroxyethyltripropylammonium hydroxide, 2-hydroxypropyltrimethylammonium hydroxide, 2-hydroxypropyltriethylammonium hydroxide, 2-hydroxypropyltripropylammonium hydroxide, dimethylbis(2-hydroxyethyl)ammonium hydroxide, diethylbis(2-hydroxyethyl)ammonium hydroxide, dipropylbis(2-hydroxyethyl)ammonium hydroxide, tris(2-hydroxyethyl)methylammonium hydroxide, tris(2-hydroxyethyl)ethylammonium hydroxide, tris(2-hydroxyethyl)propylammonium hydroxide, tetrakis(2-hydroxyethyl)ammonium hydroxide, and tetrakis(2-hydroxypropyl)ammonium hydroxide. Among these, the quaternary ammonium compound preferably includes at least one of tetramethylammonium hydroxide (TMAH) and tetraethylammonium hydroxide (TEAH), and from the viewpoint of increasing the etching amount of silicon, more preferably contains tetramethylammonium hydroxide (TMAH). The above-described quaternary ammonium compounds may be used singly or two or more kinds thereof may be used in combination.

The content of the quaternary ammonium compound is preferably 0.1% to 20% by mass, more preferably 0.2% to 10% by mass, more preferably 0.5% to 5% by mass, still more preferably 0.8% to 3% by mass, and particularly preferably 1% to 2.5% by mass with respect to the total mass of the composition.

### [Cationic Surfactant]

The cationic surfactant has a function of improving the silicon/silicon oxide etching selectivity of the composition according to the present invention.

The cationic surfactant is at least one cationic surfactant selected from the group consisting of an aryl group-containing cationic surfactant and a heteroaryl group-containing cationic surfactant. The cationic surfactant has a property of being easily introduced in a semiconductor substrate manufacturing step. Specifically, in a case where the cationic surfactant is adsorbed on a semiconductor substrate, for example, a silicon oxide film, the cationic surfactant can be removed by heating. For example, in the semiconductor substrate manufacturing step, since a step performed after the silicon etching removal with the composition (such as chemical vapor deposition (CVD), ashing, or dry etching) is performed under a high temperature condition, the cationic surfactant which may remain during the step is removed. Also, since the cationic surfactant has an aryl group or a heteroaryl group, the cationic surfactant can absorb ultraviolet light and visible light (for example, near-ultraviolet light of 250 to 300 nm). Therefore, the cationic surfactant contained in the manufactured composition can be detected by liquid chromatography using a reversed-phase column, an ultraviolet-visible spectrophotometer, or the like, and a concentration analysis of the cationic surfactant in the composition is easily performed.

### (Aryl Group-Containing Cationic Surfactant)

The aryl group-containing cationic surfactant is not particularly limited, and is preferably an aryl group-containing cationic surfactant represented by the following Formula (1).

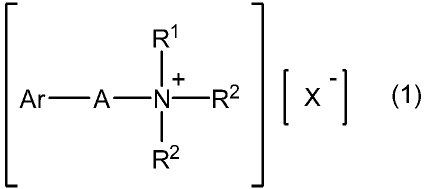

In the formula, R¹ is a substituted or unsubstituted alkyl group having 10 to 30 carbon atoms.

The alkyl group having 10 to 30 carbon atoms is not particularly limited, and examples thereof include a decyl group, an undecyl group, a dodecyl group, a tridecyl group, a tetradecyl group, a pentadecyl group, a hexadecyl group, a heptadecyl group, an octadecyl group, a nonadecyl group, and an icosyl group.

The alkyl group having 10 to 30 carbon atoms may have a substituent. The substituent is not particularly limited, and examples thereof include: an alkoxy group having 1 to 6 carbon atoms, such as a methoxy, ethoxy, or propyloxy group; a hydroxy group; a cyano group; and a nitro group. The number of substituents may be one or may be two or more.

R¹ is preferably a substituted or unsubstituted alkyl group having 10 to 20 carbon atoms, and from the viewpoint of increasing the silicon/silicon oxide etching selectivity, more preferably a substituted or unsubstituted alkyl group having 10 to 15 carbon atoms, still more preferably a dodecyl group, a tridecyl group, a tetradecyl group, or a pentadecyl group, and particularly preferably a tridecyl group, a tetradecyl group, or a pentadecyl group.

R² is each independently a substituted or unsubstituted alkyl group having 1 to 6 carbon atoms.

The alkyl group having 1 to 6 carbon atoms is not particularly limited, and examples thereof include a methyl group, an ethyl group, a propyl group, an isopropyl group, and a butyl group.

The alkyl group having 1 to 6 carbon atoms may have a substituent. The substituent is not particularly limited, and examples thereof include: an alkoxy group having 1 to 6 carbon atoms, such as a methoxy, ethoxy, or propyloxy group; a hydroxy group; a cyano group; and a nitro group. The number of substituents may be one or may be two or more.

R² is preferably a substituted or unsubstituted alkyl group having 1 to 4 carbon atoms, more preferably a substituted or unsubstituted alkyl group having 1 to 3 carbon atoms, still more preferably a methyl group or an ethyl group, and particularly preferably a methyl group.

A is a single bond or a substituted or unsubstituted alkylene having 1 to 6 carbon atoms.

The alkylene having 1 to 6 carbon atoms is not particularly limited, and examples thereof include methylene, ethylene, propylene, isopropylene, and butylene.

The alkylene having 1 to 6 carbon atoms may have a substituent. The substituent is not particularly limited, and examples thereof include: an alkoxy group having 1 to 6 carbon atoms, such as a methoxy, ethoxy, or propyloxy group; a hydroxy group; a cyano group; and a nitro group. The number of substituents may be one or may be two or more.

A is preferably a single bond or a substituted or unsubstituted alkylene having 1 to 4 carbon atoms, more preferably a single bond or a substituted or unsubstituted alkylene having 1 to 3 carbon atoms, still more preferably a single bond, or methylene or ethylene, and particularly preferably methylene.

Ar is a substituted or unsubstituted aryl group having 6 to 30 carbon atoms.

The aryl group having 6 to 30 carbon atoms is not particularly limited, and examples thereof include a phenyl group, a naphthyl group, and an anthracenyl group.

The aryl group having 6 to 30 carbon atoms may have a substituent. The substituent is not particularly limited, and examples thereof include: an alkyl group having 1 to 10 carbon atoms, such as a methyl group, an ethyl group, a propyl group, an isopropyl group, or a butyl group; an alkoxy group having 1 to 6 carbon atoms, such as a methoxy, ethoxy, or propyloxy group; a hydroxy group; a cyano group; and a nitro group. The number of substituents may be one or may be two or more.

Ar is preferably a substituted or unsubstituted aryl group having 6 to 20 carbon atoms, more preferably a substituted or unsubstituted phenyl group or a substituted or unsubstituted naphthyl group, still more preferably a substituted or unsubstituted phenyl group, and particularly preferably a phenyl group.

X⁻ is a halide ion (a fluoride ion, a chloride ion, a bromide ion, and an iodide ion), a hydroxide ion, a sulfate ion, a hydrogen sulfate ion, a sulfite ion, a thiosulfate ion, a nitrate ion, a phosphate ion, a monohydrogen phosphate ion, a dihydrogen phosphate ion, a carbonate ion, a hydrogen carbonate ion, or a carboxylate ion. Among these, X⁻ is preferably a halide ion or a hydroxide ion, more preferably a halide ion, still more preferably a chloride ion or a bromide ion, and particularly preferably a chloride ion.

Specific examples of the aryl group-containing cationic surfactant include benzyldimethyldecylammonium chloride, benzyldimethyldodecylammonium chloride, benzyldimethyltetradecylammonium chloride (BDMTDA), benzyldimethylhexadecylammonium chloride (BDMHDA), benzyldimethyloctadecylammonium chloride, benzyldimethyldecylammonium bromide, benzyldimethyldodecylammonium bromide, benzyldimethyltetradecylammonium bromide, benzyldimethylhexadecylammonium bromide, benzyldimethyloctadecylammonium bromide, benzyldiethyldecylammonium chloride, benzyldiethyldodecylammonium chloride, benzyldiethyltetradecylammonium chloride, benzyldiethylhexadecylammonium chloride, benzyldiethyloctadecylammonium chloride, benzylethylmethyldecylammonium chloride, benzylethylmethyldodecylammonium chloride, benzylethylmethyltetradecylammonium chloride, benzylethylmethylhexadecylammonium chloride, benzylethylmethyloctadecylammonium chloride, dimethylphenyldecylammonium chloride, dimethylphenyldodecylammonium chloride, dimethylphenyltetradecylammonium chloride, dimethylphenylhexadecylammonium chloride, dimethylphenyloctadecylammonium chloride, diethylphenyldecylammonium chloride, diethylphenyldodecylammonium chloride, diethylphenyltetradecylammonium chloride, diethylphenylhexadecylammonium chloride, diethylphenyl octadecyl ammonium chloride, ethylmethylphenyldecylammonium chloride, ethylmethylphenyldodecylammonium chloride, ethylmethylphenyltetradecylammonium chloride, ethylmethylphenylhexadecylammonium chloride, ethylmethylphenyloctadecylammonium chloride, dimethylnaphthyldecylammonium chloride, dimethylnaphthyldodecylammonium chloride, dimethylnaphthyltetradecylammonium chloride, dimethylnaphthylhexadecylammonium chloride, dimethylnaphthyloctadecylammonium chloride, diethylnaphthyldecylammonium chloride, diethylnaphthyldodecylammonium chloride, diethylnaphthyltetradecylammonium chloride, diethylnaphthylhexadecylammonium chloride, diethylnaphthyloctadecylammonium chloride, ethylmethylnaphthyldecylammonium chloride, ethylmethylnaphthyldodecylammonium chloride, ethylmethylnaphthyltetradecylammonium chloride, ethylmethylnaphthylhexadecylammonium chloride, and ethylmethylnaphthyloctadecylammonium chloride. Among these, the aryl group-containing cationic surfactant is preferably benzyldimethyldodecylammonium chloride, benzyldimethyltetradecylammonium chloride (BDMTDA), benzyldimethylhexadecylammonium chloride (BDMHDA), benzyldimethyldodecylammonium bromide, benzyldimethyltetradecylammonium bromide, benzyldimethylhexadecylammonium bromide, benzyldiethyldodecylammonium chloride, benzyldiethyltetradecylammonium chloride, benzyldiethylhexadecylammonium chloride, benzylethylmethyldodecylammonium chloride, benzylethylmethyltetradecylammonium chloride, or benzylethylmethylhexadecylammonium chloride, more preferably benzyldimethyldodecylammonium chloride, benzyldimethyltetradecylammonium chloride (BDMTDA), benzyldimethyldodecylammonium bromide, benzyldimethyltetradecylammonium bromide, benzyldiethyldodecylammonium chloride, benzyldiethyltetradecylammonium chloride, benzylethylmethyldodecylammonium chloride, benzylethylmethyltetradecylammonium chloride, and still more preferably benzyldimethyltetradecylammonium chloride (BDMTDA), benzyldimethyltetradecylammonium bromide, benzyldiethyltetradecylammonium chloride, or benzylethylmethyltetradecylammonium chloride

### (Heteroaryl Group-Containing Cationic Surfactant)

The heteroaryl group-containing cationic surfactant is not particularly limited, and is preferably a heteroaryl group-containing cationic surfactant represented by the following Formula (2) or (3).

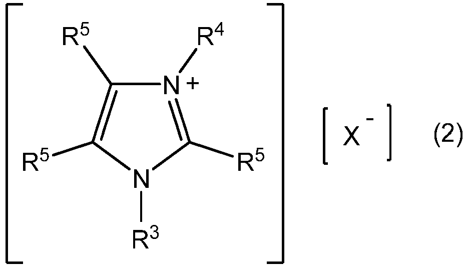

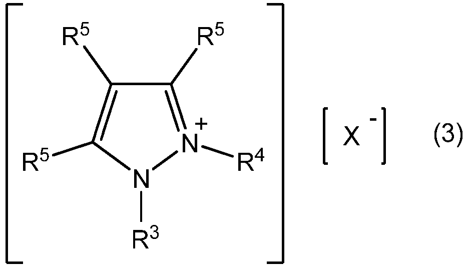

In the formula, R³ is a substituted or unsubstituted alkyl group having 10 to 30 carbon atoms. In this case, the substituted or unsubstituted alkyl group having 10 to 30 carbon atoms is the same as those described in R¹ above. Among them, R³ is preferably a substituted or unsubstituted alkyl group having 10 to 20 carbon atoms, and from the viewpoint of increasing the silicon/silicon oxide etching selectivity, more preferably a substituted or unsubstituted alkyl group having 14 to 20 carbon atoms, still more preferably a tetradecyl group, a pentadecyl group, a hexadecyl group, a heptadecyl group, an octadecyl group, a nonadecyl group, or an icosyl group, and particularly preferably a tetradecyl group, a pentadecyl group, a hexadecyl group, or a heptadecyl group.

R⁴ is a substituted or unsubstituted alkyl group having 1 to 6 carbon atoms. In this case, the substituted or unsubstituted alkyl group having 1 to 6 carbon atoms is the same as those described in R² above. Among them, R⁴ is preferably a substituted or unsubstituted alkyl group having 1 to 4 carbon atoms, more preferably a substituted or unsubstituted alkyl group having 1 to 3 carbon atoms, still more preferably a methyl group or an ethyl group, and particularly preferably a methyl group.

R⁵ is each independently a hydrogen atom or a substituted or unsubstituted alkyl group having 1 to 6 carbon atoms. In this case, the substituted or unsubstituted alkyl group having 1 to 6 carbon atoms is the same as those described in R² above. Among them, R⁵ is preferably a hydrogen atom or a substituted or unsubstituted alkyl group having 1 to 3 carbon atoms, more preferably a hydrogen atom, a methyl group, or an ethyl group, still more preferably a hydrogen atom or a methyl group, and particularly preferably a hydrogen atom.

X⁻ is a halide ion, a hydroxide ion, a sulfate ion, a hydrogen sulfate ion, a sulfite ion, a thiosulfate ion, a nitrate ion, a phosphate ion, a monohydrogen phosphate ion, a dihydrogen phosphate ion, a carbonate ion, a hydrogen carbonate ion, or a carboxylate ion. In this case, X' is the same as those described in Formula (1) above.

Specific examples of the heteroaryl group-containing cationic surfactant include an imidazolyl group-containing cationic surfactants represented by Formula (2), such as 1-dodecyl-3-methylimidazolium chloride (DMI), 1-tetradecyl-3-methylimidazolium chloride, 1-hexadecyl-3-methylimidazolium chloride (HDMI), 1-octadecyl-3-methylimidazolium chloride, 1-dodecyl-3-methylimidazolium bromide, 1-tetradecyl-3-methylimidazolium bromide, 1-hexadecyl-3-methylimidazolium bromide, 1-octadecyl-3-methylimidazolium bromide, 1-dodecyl-3-ethylimidazolium chloride, 1-tetradecyl-3-ethylimidazolium chloride, 1-hexadecyl-3-ethylimidazolium chloride, and 1-octadecyl-3-ethylimidazolium chloride; and a pyrazolyl group-containing cationic surfactant represented by Formula (3), such as 1-dodecyl-3-methylpyrazolyl chloride, 1-tetradecyl-3-methylpyrazolyl chloride, 1-hexadecyl-3-methylpyrazolyl chloride, 1-octadecyl-3-methylpyrazolyl chloride, 1-dodecyl-3-methylpyrazolyl bromide, 1-tetradecyl-3-methylpyrazolyl bromide, 1-hexadecyl-3-methylpyrazolyl bromide, 1-octadecyl-3-methylpyrazolyl bromide, 1-dodecyl-3-ethylpyrazolyl chloride, 1-tetradecyl-3-ethylpyrazolyl chloride, 1-hexadecyl-3-ethylpyrazolyl chloride, 1-octadecyl-3-ethylpyrazolyl chloride. Among these, the heteroaryl group-containing cationic surfactant is preferably an imidazolyl group-containing cationic surfactant represented by Formula (2), more preferably 1-tetradecyl-3-methylimidazolium chloride, 1-hexadecyl-3-methylimidazolium chloride (HDMI), 1-octadecyl-3-methylimidazolium chloride, 1-tetradecyl-3-methylimidazolium bromide, 1-hexadecyl-3-methylimidazolium bromide, 1-octadecyl-3-methylimidazolium bromide, 1-tetradecyl-3-ethylimidazolium chloride, 1-hexadecyl-3-ethylimidazolium chloride, or 1-octadecyl-3-ethylimidazolium chloride, and still more preferably 1-hexadecyl-3-methylimidazolium chloride (HDMI), 1-hexadecyl-3-methylimidazolium bromide, or 1-hexadecyl-3-ethylimidazolium chloride.

The cationic surfactants described above may be used singly or two or more kinds thereof may be used in combination

The content of the cationic surfactant is preferably 0.00001% to 1% by mass, more preferably 0.0001% to 1% by mass, and still more preferably 0.001% to 0.5% by mass with respect to the total mass of the composition, and from the viewpoint of increasing the silicon/silicon oxide etching selectivity, the content is particularly preferably 0.008% to 0.5% by mass, and most preferably 0.01% to 0.04% by mass.

### [Other Surfactants]

The composition according to the present invention may further contain other surfactants. Examples of other surfactants include other cationic surfactants, anionic surfactants, nonionic surfactants, and amphoteric surfactants.

The other cationic surfactants are cationic surfactants other than the aryl group-containing cationic surfactant and the heteroaryl group-containing cationic surfactant described above. The other cationic surfactants are not particularly limited, and examples thereof include decyltrimethylammonium chloride, dodecyltrimethylammonium chloride, tetradecyltrimethylammonium chloride, hexadecyltrimethylammonium chloride, octadecyltrimethylammonium chloride, decyltrimethylammonium bromide, dodecyltrimethylammonium bromide, tetradecyltrimethylammonium bromide, hexadecyltrimethylammonium bromide (HDTMA), octadecyltrimethylammonium bromide, decyltriethylammonium chloride, dodecyltriethylammonium chloride, tetradecyltriethylammonium chloride, hexadecyltriethylammonium chloride, octadecyltriethylammonium chloride, decyldimethylethylammonium chloride, dodecyldimethylethylammonium chloride, tetradecyldimethylethylammonium chloride, hexadecyldimethylethylammonium chloride, octadecyldimethylethylammonium chloride, decyldiethylmethylammonium chloride, dodecyldiethylmethylammonium chloride, tetradecyldiethylmethylammonium chloride, hexadecyldiethylmethylammonium chloride, and octadecyldiethylmethylammonium chloride.

The anionic surfactant is not particularly limited, and examples thereof include alkyl sulfates such as sodium decylbenzenesulfonate, sodium decylbenzenesulfonate, sodium dodecyl sulfate, sodium tetradecyl sulfate, sodium hexadecyl sulfate, and sodium octadecyl sulfate; alkylbenzenesulfonates such as sodium decylbenzenesulfonate, sodium dodecylbenzenesulfonate, sodium tetradecylbenzenesulfonate, sodium hexadecylbenzenesulfonate, and sodium octadecylbenzenesulfonate; and alkyl polyoxyethylene sulfates such as sodium polyoxyethylene decyl ether sulfate, sodium polyoxyethylene dodecyl ether sulfate, sodium polyoxyethylene tetradecyl ether sulfate, sodium polyoxyethylene hexadecyl ether sulfate, and sodium polyoxyethylene octadecyl ether sulfate.

The nonionic surfactant is not particularly limited, and examples thereof include glycerin fatty acid esters such as glycerin caprate, glycerin laurate, glycerin myristate, glycerin palmitate, and glycerin stearate; and polyoxyethylene ether fatty acid esters such as polysorbate 20 (Tween 20), polysorbate 60 (Tween 60), and polysorbate 80 (Tween 80).

The amphoteric surfactant is not particularly limited, and examples thereof include cocamidopropyl betaine, cocamidopropyl hydroxysultaine, and ethylene oxide alkylamine.

The other surfactants described above may be used singly or two or more kinds thereof may be used in combination.

### [Acidic Compound]

The composition according to the present invention may contain an acidic compound. The acidic compound has a function of adjusting the pH of the composition.

The acidic compound is not particularly limited, and examples thereof include inorganic acidic compounds and organic acidic compounds.

The inorganic acidic compound is not particularly limited, and examples thereof include hydrochloric acid, hydrobromic acid, sulfuric acid, nitric acid, and phosphoric acid.

The organic acidic compound is not particularly limited, and examples thereof include methanesulfonic acid, benzenesulfonic acid, p-toluenesulfonic acid, acetic acid, citric acid, and lactic acid.

The acidic compound described above may be used singly or two or more kinds thereof may be used in combination. The addition amount of the acidic compound is preferably an amount at which the pH of the composition becomes a desired value.

### [Water]

The composition may contain water. Water has a function of dispersing a quaternary ammonium compound, a cationic surfactant, and the like. In one preferred embodiment, the composition contains water.

The content of water is preferably 10% to 99.9% by mass and more preferably 15% to 99% by mass with respect to the total mass of the composition.

### [Organic Solvent]

The composition according to the present invention can contain an organic solvent. The solvent has a function of dispersing a quaternary ammonium compound, a cationic surfactant, or the like, a function of improving the silicon/silicon oxide etching selectivity of the composition according to the present invention, and the like. In one preferred embodiment, the composition preferably further contains an organic solvent.

The organic solvent is not particularly limited, and examples thereof include an alkanolamine, an aprotic polar solvent, a monoalcohol, a polyhydric alcohol, an ether, and a glycol ether.

The alkanolamine is not particularly limited, and examples thereof include monomethanolamine, monoethanolamine (MEA), N-methylethanolamine, N-ethylethanolamine, N-cyclohexylethanolamine, N-(2-aminoethyl) ethanolamine, O-(2-hydroxyethyl) ethanolamine, N,N-dimethylethanolamine, N,N-diethylethanolamine, diethanolamine, N-methyldiethanolamine, N-ethyldimethanolamine, diisopropanolamine, triethanolamine, and triisopropanolamine.

The aprotic polar solvent is not particularly limited, and examples thereof include dimethylsulfoxide (DMSO), dimethylformamide (DMA), diethylformamide (DEA), dimethylacetamide, N-methylpyrrolidone, acetonitrile, and hexamethylphosphoric acid triamide.

The monoalcohol is not particularly limited, and examples thereof include methanol, ethanol, propanol, isopropyl alcohol (IPA), 1-butanol, tert-butanol, 1-pentanol, 1-hexanol, 1-heptanol, 1-octanol, 1-nonanol, and 1-decanol.

The polyhydric alcohol is not particularly limited, and examples thereof include ethylene glycol (EG), propylene glycol, neopentyl glycol, 1,2-hexanediol, 1,6-hexanediol, 2-ethylhexane-1,3-diol, and glycerin. In the present specification, "polyhydric" means dihydric or higher, preferably dihydric, trihydric, or tetrahydric, more preferably dihydric or trihydric, and still more preferably dihydric.

The ether is not particularly limited, and examples thereof include dimethyl ether, diethyl ether, tetrahydrofuran, and 1,4-dioxane.

The glycol ether is not particularly limited, and examples thereof include ethylene glycol monomethyl ether, ethylene glycol monoethyl ether, ethylene glycol monobutyl ether, ethylene glycol n-butyl ether (2-butoxyethanol), ethylene glycol monophenyl ether (phenyl glycol), propylene glycol monomethyl ether, propylene glycol monoethyl ether, propylene glycol n-propyl ether, propylene glycol n-butyl ether, propylene glycol phenyl ether, diethylene glycol monomethyl ether, diethylene glycol monoethyl ether, diethylene glycol monobutyl ether, diethylene glycol monophenyl ether, dipropylene glycol monomethyl ether, dipropylene glycol monoethyl ether, dipropylene glycol n-propyl ether, dipropylene glycol n-butyl ether, tripropylene glycol monomethyl ether, tripropylene glycol n-propyl ether, tripropylene glycol n-butyl ether, and dipropylene glycol dimethyl ether.

Among these, the organic solvent preferably contains at least one selected from the group consisting of an alkanolamine, an aprotic polar solvent, a monoalcohol, and a polyhydric alcohol, more preferably contains at least one selected from the group consisting of an alkanolamine, an aprotic polar solvent, and a polyhydric alcohol, and from the viewpoint of increasing the silicon/silicon oxide etching selectivity, the organic solvent still more preferably contains at least one selected from the group consisting of an alkanolamine and an aprotic polar solvent, still further preferably contains an alkanolamine, particularly preferably contains at least one selected from the group consisting of monomethanolamine, monoethanolamine (MEA), N-methylethanolamine, N-ethylethanolamine, N-cyclohexylethanolamine, N-(2-aminoethyl) ethanolamine, O-(2-hydroxyethyl) ethanolamine, N,N-dimethylethanolamine, and N,N-diethylethanolamine, and most preferably at least one selected from monomethanolamine and monoethanolamine (MEA). In addition, in one embodiment, the organic solvent preferably contains at least one selected from the group consisting of monomethanolamine, monoethanolamine (MEA), dimethyl sulfoxide (DMSO), methanol, ethanol, propanol, isopropyl alcohol (IPA), ethylene glycol (EG), and propylene glycol, more preferably contains at least one selected from monoethanolamine (MEA), dimethyl sulfoxide (DMSO), isopropyl alcohol (IPA), and ethylene glycol (EG), still more preferably contains at least one selected from monoethanolamine (MEA), dimethyl sulfoxide (DMSO), and ethylene glycol (EG), and from the viewpoint of increasing the silicon/silicon oxide etching selectivity, the organic solvent particularly preferably contains at least one selected from monoethanolamine (MEA) and dimethyl sulfoxide (DMSO), and most preferably contains monoethanolamine (MEA).

The organic solvent described above may be used singly or two or more kinds thereof may be used in combination.

The content of the organic solvent is preferably 5% to 90% by mass, more preferably 15% to 85% by mass with respect to the total mass of the composition, and from the viewpoint of increasing the silicon/silicon oxide etching selectivity, still more preferably 40% to 80% by mass, and particularly preferably 55% to 75% by mass.

In one embodiment, the content of a total solvent of the composition is preferably 80% to 99.9% by mass, more preferably 85% to 99.5% by mass, and still more preferably 90% to 99% by mass with respect to the total mass of the composition. In the present specification, the "content of a total solvent" means the content of water in a case where the composition contains only water as a solvent, means the content of an organic solvent in a case where the composition contains only an organic solvent as a solvent, and means a total content of water and an organic solvent in a case where the composition contains water and an organic solvent as solvents.

### [Physical Properties of Composition]

The pH of the composition according to the present invention is preferably 8 or more, more preferably 10 or more, still more preferably 13 or more, particularly preferably 13 to 16, and most preferably 13 to 14. When the pH is 8 or more, the silicon/silicon oxide etching selectivity is increased, which is preferable. When the pH of the composition is 8 or more, that is, the liquid property of the composition is basic, a difference in surface potentials (ζ potential) of silicon and silicon oxide may occur when the composition is brought into contact. Specifically, since a silicon oxide surface has more silanol groups (-SiOH) than a silicon surface, protons are lost from the silanol groups (-SiO⁻) under a basic condition, so that a silicon oxide surface will have more negative charges. As a result, the cationic surfactant contained in the composition is more likely to adsorb to the silicon oxide surface, so that the silicon/silicon oxide etching selectivity can be increased.

An etching rate of silicon of the composition according to the present invention is not particularly limited, but is preferably 50 Å/min or more, more preferably 80 to 500 Å/min, still more preferably 120 to 400 Å/min, and particularly preferably 150 to 300 Å/min. When the etching rate of silicon is 50 Å/min or more, production efficiency is excellent, which is preferable. The etching rate of silicon can be calculated from the etching amount per 30 seconds measured by a method of Example.

An etching rate of silicon oxide of the composition according to the present invention is not particularly limited, and is preferably 30 × 10⁻³ Å/min or less, more preferably 10 × 10⁻³ Å/min or less, and particularly preferably 1 × 10⁻³ Å/min or less. A lower limit value of the etching rate of silicon oxide is not particularly limited, and is, for example, 1 × 10⁻⁶ Å/min or more and 1 × 10⁻⁵ Å/min or more.

A silicon/silicon oxide etching selectivity ratio of the composition according to the present invention is not particularly limited, and is preferably 10,000 or more, more preferably 20,000 or more, still more preferably 40,000 or more, and particularly preferably 100,000 or more, and may be 200,000 or more, 220,000 or more, or 250,000 or more. An upper limit value of the silicon/silicon oxide etching selectivity ratio is not particularly limited, and is, for example, 1 million or less or 800,000 or less. In the present specification, the "silicon/silicon oxide etching selectivity ratio" means a ratio of an etching rate (A/min) of silicon to an etching rate (A/min) of silicon oxide (etching rate of silicon/etching rate of silicon oxide).

### [Application]

The composition according to the present invention is suitably used for manufacturing a semiconductor substrate. The configuration of the semiconductor substrate is not particularly limited, and may be any of a MOS type, a bipolar type, and a BiCMOS type. In addition, the semiconductor substrate can be used for semiconductor elements of a diode, a solar cell, a DRAM, a flash memory logic, a sensor, an actuator, a converter, or the like.

### <Semiconductor Substrate Manufacturing Method>

According to an embodiment of the present invention, a semiconductor substrate manufacturing method is provided. A semiconductor substrate manufacturing method includes a silicon etching step of bringing a semiconductor substrate including a silicon region containing silicon and a silicon oxide region containing silicon oxide into contact with the composition described above.

The silicon is not particularly limited, and examples thereof include polysilicon, amorphous silicon, and single crystal silicon. In this case, the silicon is preferably polysilicon or amorphous silicon, and more preferably polysilicon. In the present specification, the "silicon" means a compound containing 80 at% or more, preferably 90 at% or more, and more preferably 95 to 100 at% of silicon (Si) atoms. In this case, the silicon may further contain at least one selected from the group consisting of a phosphorus (P) atom, a boron (B) atom, and an arsenic (As) atom. In the present specification, the atom content (at%) in the compound can be determined by measuring the atom content of a target atom by an ion sputtering method of X-ray photoelectron spectroscopy (XPS). For example, in the measurement of the atom content of silicon (Si) atoms of silicon, the atom content of silicon (Si) atoms in the vicinity of a surface of silicon may be lower than that in the inside of a material due to oxidation or carbon contamination. Therefore, the surface of silicon is etched by ion sputtering until the atom content of silicon (Si) atoms becomes constant, and the atom content of silicon (Si) atoms inside silicon exposed by ion sputtering can be measured.

Also, the silicon oxide is not particularly limited, and examples thereof include silicon oxide, tetraethoxysilane (TEOS), borophospho silicate glass (BPSG), boro silicate glass (BSG), and phospho silicate glass (PSG). In this case, in the present specification, the "silicon oxide" means a compound containing a total of 60 at% or more, preferably 70 at% or more, and more preferably 75 to 100 at% of silicon (Si) atoms and oxygen (O) atoms, and containing less than 50 at%, preferably 40 at% or less, and more preferably 15 to 35 at% of silicon (Si) atoms.

Here, the configuration of the semiconductor substrate is not particularly limited as long as the semiconductor substrate includes a silicon region containing silicon and a silicon oxide region containing silicon oxide in a manufacturing step, and may be any of a MOS type, a bipolar type, and a BiCMOS type. Among these, the configuration of the semiconductor substrate is preferably a MOS type. Examples of the semiconductor substrate including a silicon region containing silicon and a silicon oxide region containing silicon oxide include a MOSFET illustrated in Fig. 1.

Fig. 1 is a schematic view of a semiconductor substrate (before etching) in a process of manufacturing a MOSFET by a gate-last method. In a semiconductor substrate (before etching) 10, a sacrificial insulating film (silicon oxide region) 12 made of silicon oxide, a sacrificial gate electrode (silicon region) 13 made of polysilicon, and an insulating sidewall 14 are formed on a silicon substrate 11. Here, the silicon substrate 11 has an element isolation film 15 that defines a MOS region. In addition, the silicon substrate 11 has an extension region 16 formed by implanting impurities and performing high-temperature annealing, a source-drain 17 formed by implanting impurities and performing high-temperature annealing, and a silicide region 18 formed by silicidation. On the silicon substrate 11, an insulating film 19 is formed in a region other than the sacrificial insulating film (silicon oxide region) 12, the sacrificial gate electrode (silicon region) 13, and the insulating sidewall 14. Such a semiconductor substrate can be appropriately manufactured by a known technique.

In one embodiment, the silicon in the silicon region containing silicon is etched by bringing the semiconductor substrate into contact with the composition according to the present invention. For example, by treating the semiconductor substrate (before etching) 10 of Fig. 1 with the composition according to the present invention, the sacrificial gate electrode (silicon region) 13 made of polysilicon is selectively etched. In this case, the sacrificial insulating film (silicon oxide region) 12 made of silicon oxide is hardly etched. Even in a case where the sacrificial gate electrode (silicon region) 13 made of polysilicon is etched, the sacrificial insulating film (silicon oxide region) 12 remains, and thus, for example, a contact surface between the silicon substrate 11 and the sacrificial insulating film (silicon oxide region) 12 in Fig. 1 is not corroded.

The contact method in the silicon etching step is not particularly limited, and the semiconductor substrate may be immersed in the composition, the composition may be sprayed to the semiconductor substrate, or the composition may be dropped (single wafer spin treatment or the like). In this case, the immersion may be repeated two or more times, the spraying may be repeated two or more times, the dropping may be repeated two or more times, or the immersion, the spraying, and the dropping may be combined.

The contact temperature in the silicon etching step is not particularly limited, and is preferably 0°C to 90°C, more preferably 15°C to 80°C, and still more preferably 20°C to 70°C.

The contact time in the silicon etching step is not particularly limited, and is preferably 10 seconds to 3 hours, more preferably 10 seconds to 1 hour, still more preferably 10 seconds to 45 minutes, and particularly preferably 20 seconds to 5 minutes.

In one embodiment, the semiconductor substrate manufacturing method may further include a silicon oxide etching step of bringing the semiconductor substrate including a silicon oxide region containing silicon oxide into contact with an etching solution. For example, in the semiconductor substrate from which the sacrificial gate electrode (silicon region) has been removed, the sacrificial insulating film (silicon oxide region) is removed using an etching solution. As a result, for example, the silicon substrate surface is exposed. A part of the sacrificial insulating film (silicon oxide region) may remain.

The etching solution used in the silicon oxide etching step is not particularly limited, and examples thereof include a mixed solution of hydrofluoric acid (HF) and nitric acid, a hydrofluoric acid solution, an acidic ammonium fluoride aqueous solution, and an ammonium fluoride aqueous solution.

The contact method in the silicon oxide etching step is not particularly limited, and the semiconductor substrate may be immersed in an etching solution, the etching solution may be sprayed to the semiconductor substrate, or the etching solution may be dropped (single wafer spin treatment or the like). In this case, the immersion may be repeated two or more times, the spraying may be repeated two or more times, the dropping may be repeated two or more times, or the immersion, the spraying, and the dropping may be combined.

The contact temperature in the silicon oxide etching step is not particularly limited, and is preferably 0°C to 90°C, more preferably 15°C to 80°C, and still more preferably 20°C to 70°C.

The contact time in the silicon oxide etching step is not particularly limited, and is preferably 10 seconds to 3 hours, more preferably 10 seconds to 1 hour, still more preferably 10 seconds to 45 minutes, and particularly preferably 20 seconds to 5 minutes.

In one embodiment, the semiconductor substrate manufacturing method may further include a step of forming a high dielectric constant (High-k) insulator and a step of forming a metal gate. For example, in a semiconductor substrate from which a sacrificial insulating film (silicon oxide region) and a sacrificial gate electrode (silicon region) have been removed, a high dielectric constant (High-k) insulator is formed in a film shape, and then a metal gate is formed in a film shape, whereby a MOSFET can be manufactured.

The high dielectric constant (High-k) insulator is not particularly limited, and examples thereof include hafnium silicate, zirconium silicate, hafnium oxide, zirconia, lanthanum oxide, tantalum oxide, and aluminum oxide. These high dielectric constant (High-k) insulators may be used singly or two or more kinds thereof may be used in combination. In the present specification, the "high dielectric constant" means that the relative dielectric constant is 4 or more, preferably 10 or more, and more preferably 20 or more.

A film formation method in the step of forming a high dielectric constant (High-k) insulator is not particularly limited, and examples thereof include atomic layer deposition (ALD), chemical phase adsorption (CVD), and physical vapor deposition (PVD). These methods may be used singly or two or more kinds thereof may be used in combination.

Also, the metal gate is not particularly limited, and examples thereof include tantalum, tantalum nitride, tantalum silicide nitride, tantalum carbide, tantalum oxide, niobium, tungsten, tungsten nitride, ruthenium oxide, titanium nitride, molybdenum, molybdenum nitride, and aluminum titanium. These metal gates may be used singly or two or more kinds thereof may be used in combination.

A film formation method in the step of forming a metal gate is not particularly limited, and examples thereof include atomic layer deposition (ALD), chemical phase adsorption (CVD), and physical vapor deposition (PVD). These methods may be used singly or two or more kinds thereof may be used in combination.

### <Semiconductor Substrate Etching Method>

According to an embodiment of the present invention, a semiconductor substrate etching method is provided. A semiconductor substrate etching method includes a silicon etching step of bringing a semiconductor substrate including a silicon region containing silicon and a silicon oxide region containing silicon oxide into contact with the composition described above. A specific etching method for a semiconductor substrate is the same as the method described above.

### Examples

Hereinafter, the present invention will be described in more detail with reference to Examples, but the present invention is not limited to these Examples.

### [Example 1]

Tetramethylammonium hydroxide (TMAH), benzyldimethyltetradecylammonium chloride (BDMTDA), and water were mixed to produce a composition. In this case, the contents of TMAH and BDMTDA were 1.5% by mass and 0.02% by mass, respectively, with respect to the total mass of the composition. In addition, the pH of the composition was measured, and the pH was 13.4.

### [Example 2]

A composition was produced in the same manner as in Example 1, except that benzyldimethylhexadecylammonium chloride (BDMHDA) was used in place of BDMTDA. In addition, the pH of the composition was measured by the same method as in Example 1, and was found to be 13.4.

### [Example 3]

A composition was produced in the same manner as in Example 1, except that benzyldimethylhexadecylammonium chloride (BDMHDA) was used in place of BDMTDA and the content of BDMHDA was changed to 0.005% by mass. In addition, the pH of the composition was measured by the same method as in Example 1, and was found to be 13.4.

### [Example 4]

A composition was produced in the same manner as in Example 1, except that 1-hexadecyl-3-methylimidazolium chloride monohydrate (HDMI) was used in place of BDMTDA. In addition, the pH of the composition was measured by the same method as in Example 1, and was found to be 13.4.

### [Example 5]

A composition was produced in the same manner as in Example 1, except that 1-hexadecyl-3-methylimidazolium chloride monohydrate (HDMI) was used in place of BDMTDA and the content of HDMI was changed to 0.05% by mass. In addition, the pH of the composition was measured by the same method as in Example 1, and was found to be 13.4.

### [Example 6]

A composition was produced in the same manner as in Example 1, except that 1-dodecyl-3-methylimidazolium chloride (DMI) was used in place of BDMTDA. In addition, the pH of the composition was measured by the same method as in Example 1, and was found to be 13.4.

### [Example 7]

A composition was produced in the same manner as in Example 1, except that 1-dodecyl-3-methylimidazolium chloride (DMI) was used in place of BDMTDA, and the content of DMI was changed to 0.05% by mass. In addition, the pH of the composition was measured by the same method as in Example 1, and was found to be 13.4.

### [Example 8]

A composition was produced in the same manner as in Example 1, except that tetraethylammonium hydroxide (TEAH) was used in place of TMAH, and the content of TEAH was changed to 2% by mass. In addition, the pH of the composition was measured by the same method as in Example 1, and was found to be 13.3.

### [Example 9]

A composition was produced in the same manner as in Example 1, except that ethylene glycol (EG) was further added so that the content was 70% by mass. The content of water in the composition was 28.48% by mass. In addition, the pH of the composition was measured by the same method as in Example 1, and was found to be 12.9.

### [Example 10]

A composition was produced in the same manner as in Example 1, except that benzyldimethylhexadecylammonium chloride (BDMHDA) was used in place of BDMTDA, and monoethanolamine (MEA) was further added so that the content was 30% by mass. The content of water in the composition was 68.48% by mass. In addition, the pH of the composition was measured by the same method as in Example 1, and was found to be 13.9.

### [Example 11]

A composition was produced in the same manner as in Example 1 except that benzyldimethylhexadecylammonium chloride (BDMHDA) was used in place of BDMTDA, and monoethanolamine (MEA) was further added so that the content was 60% by mass. The content of water in the composition was 38.48% by mass. In addition, the pH of the composition was measured by the same method as in Example 1, and was found to be 14.9.

### [Example 12]

A composition was produced in the same manner as in Example 1, except that isopropyl alcohol (IPA) was further added so that the content was 10% by mass. The content of water in the composition was 88.48% by mass. In addition, the pH of the composition was measured by the same method as in Example 1, and was found to be 13.6.

### [Example 13]

A composition was produced in the same manner as in Example 1, except that benzyldimethylhexadecylammonium chloride (BDMHDA) was used in place of BDMTDA, and dimethyl sulfoxide (DMSO) was further added so that the content was 50% by mass. The content of water in the composition was 48.48% by mass. In addition, the pH of the composition was measured by the same method as in Example 1, and was found to be 15.4.

### [Comparative Example 1]

A composition was produced in the same manner as in Example 1, except that benzyldimethyltetradecylammonium chloride (BDMTDA) was not added. The content of water in the composition was 98.5% by mass. In addition, the pH of the composition was measured by the same method as in Example 1, and was found to be 13.6.

### [Comparative Example 2]

A composition was produced in the same manner as in Example 8, except that benzyldimethyltetradecylammonium chloride (BDMTDA) was not added. The content of water in the composition was 98% by mass. In addition, the pH of the composition was measured by the same method as in Example 1, and was found to be 13.3.

### [Comparative Example 3]

A composition was produced in the same manner as in Comparative Example 1, except that ethylene glycol (EG) was further added so that the content was 70% by mass. The content of water in the composition was 28.5% by mass. In addition, the pH of the composition was measured by the same method as in Example 1, and was found to be 12.9.

### [Comparative Example 4]

A composition was produced in the same manner as in Comparative Example 1, except that monoethanolamine (MEA) was further added so that the content was 30% by mass. The content of water in the composition was 68.5% by mass. In addition, the pH of the composition was measured by the same method as in Example 1, and was found to be 13.8.

### [Comparative Example 5]

A composition was produced in the same manner as in Comparative Example 1, except that isopropyl alcohol (IPA) was further added so that the content was 10% by mass. The content of water in the composition was 88.5% by mass. In addition, the pH of the composition was measured by the same method as in Example 1, and was found to be 13.6.

### [Comparative Example 6]

A composition was produced in the same manner as in Comparative Example 1, except that dimethyl sulfoxide (DMSO) was further added so that the content was 50% by mass. The content of water in the composition was 48.5% by mass. In addition, the pH of the composition was measured by the same method as in Example 1, and was found to be 15.4.

### [Comparative Example 7]

A composition was produced in the same manner as in Comparative Example 1, except that the content of TMAH was changed to 2% by mass, and hexadecyltrimethylammonium bromide (HDTMA) was further added so that the content was 1% by mass. The content of water in the composition was 97% by mass. In addition, the pH of the composition was measured by the same method as in Example 1, and was found to be 13.5.

The compositions produced in Examples 1 to 13 and Comparative Examples 1 to 7 are shown in Table 1 below.

**[Table 1]**

| | Quaternary ammonium compound | | Cationic surfactant | | | Organic solvent | | pH |
|---|---|---|---|---|---|---|---|---|
| | Kind^{*1} | Content (% by mass) | Kind^{*2} | The number of carbon atoms in R¹ in Formula (1) or the number of carbon atoms in R³ in Formula (2) | Content (% by mass) | Kind^{*3} | Content (% by mass) | |
| Example 1 | TMAH | 1.5 | BDMTDA | 14 | 0.02 | - | 0 | 13.4 |
| Example 2 | TMAH | 1.5 | BDMHDA | 16 | 0.02 | - | 0 | 13.4 |
| Example 3 | TMAH | 1.5 | BDMHDA | 16 | 0.005 | - | 0 | 13.4 |
| Example 4 | TMAH | 1.5 | HDMI | 16 | 0.02 | - | 0 | 13.4 |
| Example 5 | TMAH | 1.5 | HDMI | 16 | 0.05 | - | 0 | 13.4 |
| Example 6 | TMAH | 1.5 | DMI | 12 | 0.02 | - | 0 | 13.4 |
| Example 7 | TMAH | 1.5 | DMI | 12 | 0.05 | - | 0 | 13.4 |
| Example 8 | TEAH | 2 | BDMTDA | 14 | 0.02 | - | 0 | 13.3 |
| Example 9 | TMAH | 1.5 | BDMTDA | 14 | 0.02 | EG | 70 | 129 |
| Example 10 | TMAH | 1.5 | BDMHDA | 16 | 0.02 | MEA | 30 | 13.9 |
| Example 11 | TMAH | 1.5 | BDMHDA | 16 | 0.02 | MEA | 60 | 14.9 |
| Example 12 | TMAH | 1.5 | BDMTDA | 14 | 0.02 | IPA | 10 | 13.6 |
| Example 13 | TMAH | 1.5 | BDMHDA | 16 | 0.02 | DMSO | 50 | 15.4 |
| Comparative Example 1 | TMAH | 1.5 | - | - | 0 | - | 0 | 13.4 |
| Comparative Example 2 | TEAH | 2 | - | - | 0 | - | 0 | 13.3 |
| Comparative Example 3 | TMAH | 1.5 | - | - | 0 | EG | 70 | 12.9 |
| Comparative Example 4 | TMAH | 1.5 | - | - | 0 | MEA | 30 | 13.8 |
| Comparative Example 5 | TMAH | 1.5 | - | - | 0 | IPA | 10 | 13.6 |
| Comparative Example 6 | TMAH | 1.5 | - | - | 0 | DMSO | 50 | 15.4 |
| Comparative Example 7 | TMAH | 2 | HDTMA | 16 | 1 | - | - | 13.5 |

| | | | | | | | | |
|---|---|---|---|---|---|---|---|---|
| *1...TMAH: Tetramethylammonium hydroxide, TEAH: Tetraethylammonium hydroxide *2...BDMTDA: Benzyldimethyltetradecylammonium chloride, BDMHDA: Benzyldimethylhexadecylammonium chloride, HDMI: 1-Hexadecyl-3-methylimidazolium chloride monohydrate, DMI: 1-Dodecyl-3-methylimidazolium chloride, HDTMA: Hexadecyltrimethylammonium bromide *3...EG: Ethylene glycol, MEA: Monoethanolamine, IPA: Isopropyl alcohol, DMSO: Dimethyl sulfoxide | | | | | | | | |

The structural formulas of the cationic surfactants used in Examples and Comparative Examples are as follows.

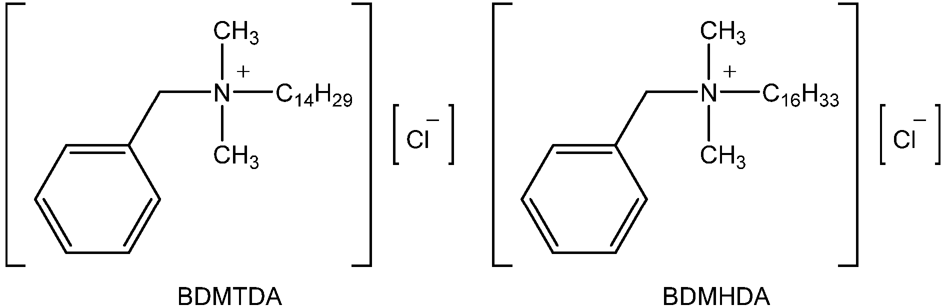

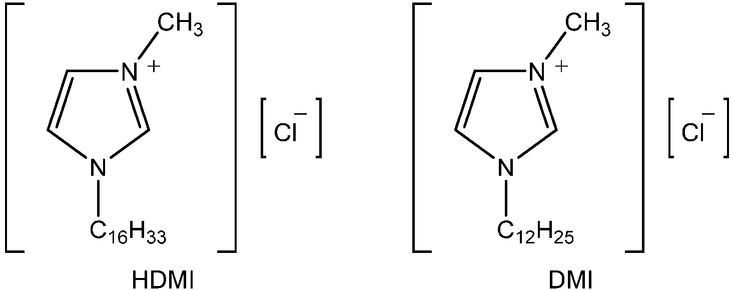

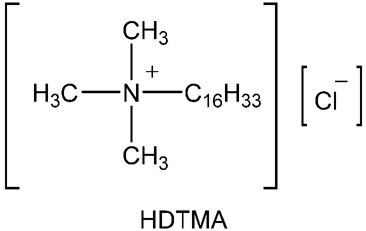

### [Evaluation]

The compositions produced in Examples 1 to 13 and Comparative Examples 1 to 7 were subjected to various evaluations.

### (Etching Amount of Polysilicon (Poly-Si) Film)

A polysilicon film (thickness: 600 Å) was formed on a silicon substrate (SiO₂ thickness: 1000 Å) having a thermal oxide film (SiO₂) by low pressure plasma CVD.

An oxide film on the surface of the polysilicon film was removed by immersing a polysilicon film formation sample of 1 cm × 1 cm (immersion treatment area: 1 cm²) in 10 mL of 1% hydrofluoric acid (DHF) at 23°C for 5 minutes. The film thickness of the polysilicon film formation sample before being immersed in 1% hydrofluoric acid (DHF) was measured using a spectroscopic ellipsometer UVISEL Plus (manufactured by HORIBA, Ltd.).

A polysilicon film formation sample was immersed in 10 g of the composition produced in Examples 1 to 13 and Comparative Examples 1 to 7 at 60°C for 30 seconds. The film thickness of the polysilicon film formation sample after the immersion treatment was measured by the same method as described above.

The etching amount of the polysilicon film per 30 seconds was determined by calculating a film thickness difference between the film thickness of the polysilicon film formation sample before being immersed in 1% hydrofluoric acid (DHF) and the film thickness of the polysilicon film formation sample after the composition treatment. The obtained results are shown in Table 2 below.

### (Etching Amount of Silicon Oxide (th-Ox) Film)

Silicon oxide was formed in a film shape by thermal oxidation of a silicon wafer to obtain a thickness of 1000 Å, and cut into a size of 1 cm × 1 cm (immersion treatment area: 1 cm²) to prepare a silicon oxide film formation sample.

The film thickness of the silicon oxide film formation sample was measured using a spectroscopic ellipsometer UVISEL Plus (manufactured by HORIBA, Ltd.).

A silicon oxide film formation sample was immersed in 10 g of the composition produced in Examples 1 to 13 and Comparative Examples 1 to 7 at 60°C for 120 minutes. The film thickness of the silicon oxide film formation sample after the immersion treatment was measured by the same method as described above.

The etching amount of the silicon oxide (th-Ox) film per 120 minutes was determined by calculating a film thickness difference of the silicon oxide film formation samples before and after the treatment. The obtained results are shown in Table 2 below.

### (Polysilicon/Silicon Oxide Etching Selectivity Ratio)

The etching rates of polysilicon and silicon oxide were calculated by dividing the etching amount of the polysilicon (Poly-Si) film and the etching amount of the silicon oxide (th-Ox) film of the composition produced in Examples 1 to 13 and Comparative Examples 1 to 7 by the immersion time. Next, the etching selectivity ratio of polysilicon (Poly-Si)/silicon oxide (th-Ox) was calculated by dividing the etching rate of polysilicon by the etching rate of silicon oxide. The unit of the etching rate of the polysilicon film or the etching rate of the silicon oxide (th-Ox) film was unified to "Å/min" for calculation. The obtained results are shown in Table 2 below.

**[Table 2]**

| | Poly-Si Etching amount (Å/30 sec) | th-Ox Etching amount (Å/120 min) | Poly-Si/th-Ox Etching selectivity ratio |
|---|---|---|---|
| Example 1 | 80 | < 0.1 | > 192000 |
| Example 2 | 85 | 0.3 | 68000 |
| Example 3 | 85 | 0.6 | 34024 |
| Example 4 | 130 | < 0.1 | > 312000 |
| Example 5 | 120 | < 0.1 | > 288800 |
| Example 6 | 87 | < 0.1 | > 208800 |
| Example 7 | 87 | < 0.1 | > 208800 |
| Example 8 | 53 | < 0.1 | > 127200 |
| Example 9 | 56 | 0.7 | 19200 |
| Example 10 | 93 | < 0.1 | > 223200 |
| Example 11 | 113 | < 0.1 | > 271200 |
| Example 12 | 59 | < 0.1 | > 141600 |
| Example 13 | 99 | < 0.1 | > 237600 |
| Comparative Example 1 | 279 | 28 | 2391 |
| Comparative Example 2 | 247 | 31 | 1882 |
| Comparative Example 3 | 127 | 4 | 7620 |
| Comparative Example 4 | 411 | 11 | 8967 |
| Comparative Example 5 | 181 | 26 | 1677 |
| Comparative Example 6 | 188 | 5 | 8988 |
| Comparative Example 7 | 107 | 9 | 2853 |

From the results in Table 2, it can be seen that in the compositions of Examples 1 to 13, polysilicon was selectively etched.

### Reference Signs List

- 10: Semiconductor substrate (before etching)
- 11: Silicon substrate
- 12: Sacrificial insulating film (silicon oxide region)
- 13: Sacrificial gate electrode (silicon region)
- 14: Insulating sidewall
- 15: Element isolation film
- 16: Extension region
- 17: Source-drain
- 18: Silicide region
- 19: Insulating film

## Claims

1. A composition comprising:
a quaternary ammonium compound; and
at least one cationic surfactant selected from the group consisting of an aryl group-containing cationic surfactant and a heteroaryl group-containing cationic surfactant.

2. The composition according to claim 1, wherein the aryl group-containing cationic surfactant is represented by the following Formula (1): 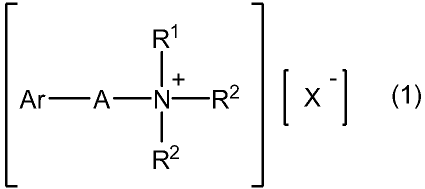 [wherein,
R¹ is a substituted or unsubstituted alkyl group having 10 to 30 carbon atoms,
R² is each independently a substituted or unsubstituted alkyl group having 1 to 6 carbon atoms,
A is a single bond or a substituted or unsubstituted alkylene having 1 to 6 carbon atoms,
Ar is a substituted or unsubstituted aryl group having 6 to 30 carbon atoms, and
X⁻ is a halide ion, a hydroxide ion, a sulfate ion, a hydrogen sulfate ion, a sulfite ion, a thiosulfate ion, a nitrate ion, a phosphate ion, a monohydrogen phosphate ion, a dihydrogen phosphate ion, a carbonate ion, a hydrogen carbonate ion, or a carboxylate ion].

3. The composition according to claim 2, wherein R¹ is a substituted or unsubstituted alkyl group having 10 to 15 carbon atoms.

4. The composition according to any one of claims 1 to 3, wherein the heteroaryl group-containing cationic surfactant is represented by the following Formula (2) or (3): 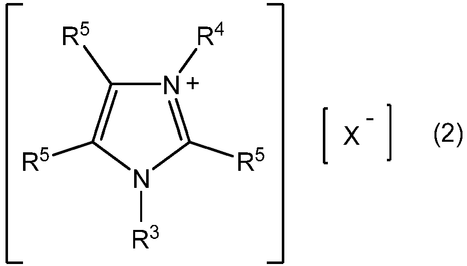 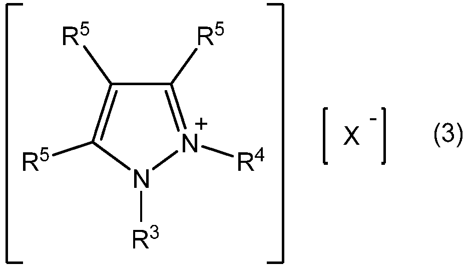 [wherein,
R³ is a substituted or unsubstituted alkyl group having 10 to 30 carbon atoms,
R⁴ is a substituted or unsubstituted alkyl group having 1 to 6 carbon atoms,
R⁵ is each independently a hydrogen atom or a substituted or unsubstituted alkyl group having 1 to 6 carbon atoms, and
X⁻ is a halide ion, a hydroxide ion, a sulfate ion, a hydrogen sulfate ion, a sulfite ion, a thiosulfate ion, a nitrate ion, a phosphate ion, a monohydrogen phosphate ion, a dihydrogen phosphate ion, a carbonate ion, a hydrogen carbonate ion, or a carboxylate ion].

5. The composition according to claim 4, wherein R³ is a substituted or unsubstituted alkyl group having 14 to 20 carbon atoms.

6. The composition according to any one of claims 1 to 5, further comprising an organic solvent.

7. The composition according to claim 6, wherein the organic solvent includes at least one selected from the group consisting of an alkanolamine, an aprotic polar solvent, a monoalcohol, and a polyhydric alcohol.

8. The composition according to any one of claims 1 to 7, wherein the quaternary ammonium compound includes tetramethylammonium hydroxide (TMAH).

9. A semiconductor substrate manufacturing method comprising: a silicon etching step of bringing a semiconductor substrate including a silicon region containing silicon and a silicon oxide region containing silicon oxide into contact with the composition according to any one of claims 1 to 8.

10. A semiconductor substrate etching method comprising: a silicon etching step of bringing a semiconductor substrate including a silicon region containing silicon and a silicon oxide region containing silicon oxide into contact with the composition according to any one of claims 1 to 8.
